# EUROPEAN PATENT APPLICATION

(11) **EP 2 586 752 A1**
(43) Date of publication of application: **01.05.2013**
(21) Application number: 12007332.5
(22) Date of filing: 25.10.2012
(51) Int. Cl.: C03C 8/18, H01B 1/16, H01B 1/22

(54) **Electroconductive paste composition containing metal nanoparticles**

(30) Priority: 25.10.2011 US 201161550998 P
(71) Applicant: Heraeus Precious Metals North America Conshohocken LLC, West Conshohocken, PA 19428 (US)
(72) Inventor: Chen, Chilong, 120509 Singapore (SG); Zhang, Weiming, Blue Bell, Pennsylvania 19422 (US); GUO, Tracy, Horsham, Pennsylvania 19044 (US)
(74) Representative: Herzog, Martin

(57) **Abstract**

An electroconductive paste composition, particularly for solar cells, contains silver particles, glass frit, an organic vehicle, and a nanoparticle additive. The additive contains electrically conductive metal, metal alloy, and/or metal silicide nanoparticles, such as nickel, chromium, cobalt, titanium, or alloys, silicides, and mixtures thereof. When used to form an electrical contact on a solar cell, such a paste provides for decreased contact resistance between the paste and the substrate and improved efficiency of the solar cell.

## Description

### CROSS-REFERENCE TO RELATED APPLICATIONS

This application claims priority to U.S. Provisional Application No. 61/550,998 filed October 25, 2011, the disclosure of which is incorporated herein by reference in its entirety.

### FIELD OF THE INVENTION

Solar cells are devices that convert the energy of light into electricity using the photovoltaic effect. Solar power is an attractive green energy source because it is sustainable and produces only non-polluting by-products. Accordingly, a great deal of research is currently being devoted to developing solar cells with enhanced efficiency while continuously lowering material and manufacturing costs. When light hits a solar cell, a fraction of the incident light is reflected by the surface and the remainder is transmitted into the solar cell. The photons of the transmitted light are absorbed by the solar cell, which is usually made of a semiconducting material, such as silicon. The energy from the absorbed photons electrons of the semiconducting material from their atoms, generating electron-hole pairs. These electron-hole pairs are then separated by p-n junctions and collected by conductive electrodes which are applied on the solar cell surface.

The most common solar cells are those made of silicon. Specifically, a p-n junction is made from silicon by applying an n-type diffusion layer onto a p-type silicon substrate, coupled with two electrical contact layers or electrodes. In a p-type semiconductor, dopant atoms are added to the semiconductor in order to increase the number of free charge carriers (positive holes). Essentially, the doping material takes away weakly bound outer electrons from the semiconductor atoms. One example of a p-type semiconductor is silicon with a boron or aluminum dopant. Solar cells can also be made from n-type semiconductors. In an n-type semiconductor, the dopant atoms provide extra electrons to the host substrate, creating an excess of negative electron charge carriers. One example of an n-type semiconductor is silicon with a phosphorous dopant. In order to minimize reflection of the sunlight by the solar cell, an antireflection coating, such as silicon nitride, is applied to the n-type diffusion layer to increase the amount of light coupled into the solar cell.

Silicon solar cells typically have electroconductive pastes applied to both their front and back surfaces. As part of the metallization process, a rear contact is typically first applied to the silicon substrate, such as by screen printing back side silver paste or silver/aluminum paste to form soldering pads. Next, an aluminum paste is applied to the entire back side of the substrate to form a back surface field (BSF), and the cell is then dried. Next, using a different type of electroconductive paste, a metal contact may be screen printed onto the front side antireflection layer to serve as a front electrode. This electrical contact layer on the face or front of the cell, where light enters, is typically present in a grid pattern made of "finger lines" and "bus bars," rather than a complete layer, because the metal grid materials are typically not transparent to light. The silicon substrate with printed front side and back side paste is then fired at a temperature of approximately 700-795°C. After firing, the front side paste etches through the antireflection layer, forms electrical contact between the metal grid and the semiconductor, and converts the metal pastes to metal electrodes. On the back side, the aluminum diffuses into the silicon substrate, acting as a dopant which creates the BSF. The resulting metallic electrodes allow electricity to flow to and from solar cells connected in a solar panel.

To assemble a panel, multiple solar cells are connected in series and/or in parallel and the ends of the electrodes of the first cell and the last cell are preferably connected to output wiring. The solar cells are typically encapsulated in a transparent thermal plastic resin, such as silicon rubber or ethylene vinyl acetate. A transparent sheet of glass is placed on the front surface of the encapsulating transparent thermal plastic resin. A back protecting material, for example, a sheet of polyethylene terephthalate coated with a film of polyvinyl fluoride having good mechanical properties and good weather resistance, is placed under the encapsulating thermal plastic resin. These layered materials may be heated in an appropriate vacuum furnace to remove air, and then integrated into one body by heating and pressing. Furthermore, since solar cells are typically left in the open air for a long time, it is desirable to cover the circumference of the solar cell with a frame material consisting of aluminum or the like.

A typical silver electroconductive paste contains metallic particles, glass frit and an organic vehicle. These components must be carefully selected to take full advantage of the theoretical potential of the resulting solar cell. For example, it is desirable to maximize the contact between the metallic paste and silicon surface, and the metallic particles themselves so that the charge carriers can flow through the interface and finger lines to the bus bars. The glass particles in the composition etch through the antireflection coating layer, helping to build contacts between the metal and the P+ type Si. On the other hand, the glass must not be so aggressive that it shunts the p-n junction after firing. Thus, the goal is to minimize contact resistance while keeping the p-n junction intact so as to achieve improved efficiency. Known compositions have high contact resistance due to the insulating effect of the glass in the interface of the metallic layer and silicon wafer, as well as other disadvantages such as high recombination in the contact area. Thus, a paste is needed that improves contact between the paste and the underlying silicon substrate.

### SUMMARY OF THE INVENTION

An electroconductive paste composition according to one embodiment of the invention comprises:
(a) silver particles;
(b) glass frit;
(c) electrically conductive metal, metal alloy, and/or metal silicide nanoparticles, wherein the nanoparticles have a particle diameter of about 5 nm to about 2 microns; and
(d) an organic vehicle.

According to another embodiment, the nanoparticles comprise at least one selected from the group consisting of nickel, chromium, cobalt, titanium, and alloys, silicides, and mixtures thereof.

According to yet another embodiment, the electroconductive paste comprising about 40 to about 95% silver particles, about 0.5 to about 6 % glass frit, about 0.05 to 20 wt. % metal nanoparticles, and about 5 to about 30% organic vehicle, all percentages being by weight based on total weight of the composition.

According to another embodiment, the nanoparticles have a particle diameter of about 20 nm to about 800 nm. More preferably, the nanoparticles have a particle diameter of about 20 nm to about 500 nm.

According to another embodiment, the nanoparticles are present in an amount of about 0.05 to 10.0 wt.%. More preferably, the nanoparticles are present in an amount of about 0.05 to 5.0 wt%.

According to yet another embodiment, the electroconductive paste further comprises at least one additive selected from the group consisting of Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates in an amount of about 0.1 to 3.0 wt.%.

A solar cell electrode according to a first embodiment of the invention is formed by applying an electroconductive paste composition to a substrate and firing the paste to form the electrode, wherein the electroconductive paste composition comprises:
(a) silver particles;
(b) glass frit;
(c) electrically conductive metal, metal alloy, and/or metal silicide nanoparticles, wherein the nanoparticles have a particle diameter of about 5 nm to about 2 microns; and
(d) an organic vehicle.

According to another embodiment, the nanoparticles are at least one selected from the group consisting of nickel, chromium, cobalt, titanium, and alloys, silicides, and mixtures thereof.

According to another embodiment, the nanoparticles have a particle diameter of about 20 nm to about 800 nm. More preferably, the nanoparticles have a particle diameter of about 20 nm to about 500 nm.

According to another embodiment, the nanoparticles are present in the composition in an amount of about 0.05 to about 20% by weight based on a total weight of the composition. More preferably, the nanoparticles are present in an amount of about 0.05 to 10.0 wt%. Most preferably, the nanoparticles are present in an amount of about 0.05 to 5.0 wt %.

According to yet another embodiment, the electroconductive paste composition further comprises at least one additive selected from the group consisting of A1203, ZnO, Li2O, Ag2O, AgO, MoO3, TiO2, Te02, CoO, Co2O3, Bi2O3, CeO2, CeF4, SiO2, MgO, PbO, ZrO2, HfO2, In2O3, SnO2, P2O5, Ta2O5, B2O3, Ag3PO4, LiCoO2, LiNiO2, Ni3(PO4)2, NiO, or lithium phosphate in an amount of about 0.1 to 3.0 wt %.

A solar cell electrode according to a second embodiment of the invention is formed by applying a first layer of a first electroconductive paste composition to a substrate and drying the paste, applying a second layer of a second electroconductive paste composition to the first layer, and firing the two layers to form the electrode, wherein the first electroconductive paste composition comprises:
(a) silver particles;
(b) glass frit;
(c) electrically conductive metal, metal alloy, and/or metal silicide nanoparticles, wherein the nanoparticles have a particle diameter of about 5 nm to about 2 microns; and
(d) an organic vehicle;
and wherein the second electroconductive paste may be the same or different from the first layer paste and may or may not contain glass frit or organic vehicle, but contains electroconductive particles and preferably produces a higher electrical conductivity than the first layer paste.

According to another embodiment of the solar cell electrode, the nanoparticles are at least one selected from the group consisting of nickel, chromium, cobalt, titanium, and alloys, silicides, and mixtures thereof.

A method of forming a solar cell electrode according to an embodiment of the invention comprises applying a layer of a first electroconductive paste composition to a substrate and firing the paste to form the electrode, wherein the first electroconductive paste composition comprises:
(a) silver particles;
(b) glass frit;
(c) electrically conductive metal, metal alloy, and/or metal silicide nanoparticles, wherein the nanoparticles have a particle diameter of about 5 nm to about 2 microns; and
(d) an organic vehicle.

According to yet another embodiment of the method of forming a solar cell electrode, the nanoparticle are at least one selected from the group consisting of nickel, chromium, cobalt, titanium, and alloys, silicides, and mixtures thereof.

According to yet another embodiment, the method further comprises forming a layer of a second electroconductive paste composition on the layer of the first electroconductive paste composition.

### DETAILED DESCRIPTION OF THE INVENTION

The electroconductive paste composition according to the invention comprises four essential components: silver particles, glass frit, at least one metal/metal alloy/metal silicide nanoparticulate additive, and an organic vehicle. The metal nanoparticulate additive may contain, but is not limited to nickel, chromium, titanium, cobalt, or alloys, silicides, or mixtures thereof. As described in more detail below, such additives provide decreased contact resistance with the substrate after firing, as well as improved efficiency. A preferred embodiment includes nickel-titanium alloy nanoparticles. While not limited to such applications, such a paste may be used to form an electrical contact layer or electrode in a solar cell or other silicon semiconductor device. Specifically, the pastes may be applied to the front side of a solar cell or to the back side of a solar cell or other silicon semiconductor device.

### Silver Particles

The silver particles function as an electroconductive metal in the electroconductive paste composition. The silver may be present as silver metal, one or more silver derivatives, or a mixture thereof. Suitable silver derivatives include, for example, silver alloys and/or silver salts, such as silver halides (e.g., silver chloride), silver nitrate, silver acetate, silver trifluoroacetate, silver orthophosphate, and combinations thereof. It is also within the scope of the invention to utilize other electroconductive metals in place of or in addition to silver, such as, without limitation, gold, copper, nickel, palladium and/or platinum. Alternatively, alloys of these metals may also be utilized as the electroconductive metal..

The silver particles may be included in the composition in powder or flake form, such as powder having an average particle diameter of about 0.3 to about 10 microns. Unless otherwise indicated herein, all particle sizes stated herein are d₅₀ particle diameters measured by laser diffraction. As well understood by those in the art, the d₅₀ diameter represents the size at which half of the individual particles (by weight) are smaller than the specified diameter. Such diameters provide the metallic particle with suitable sintering behavior and spreading of the electroconductive paste on the antireflection layer when forming a solar cell through screen printing or equivalent technology, as well as appropriate contact formation and conductivity of the resulting solar cell electrode.

The metal conductive portion of the composition may contain, but is not limited to, mono-dispersed silver powders with d₅₀ of about 0.3 to 10 microns, mixtures of different mono-dispersed silver powders with d₅₀ of about 0.3 to 10 microns, bi-dispersed, or multi-dispersed powders with various size concentrations peaks of about 0.3 to 10 microns. The silver particles are preferably present in the composition in an amount of about 40 to about 95 % by weight based on the total weight of the composition, more preferably about 70 to 90 wt%.

### Glass Frit

The glass frit (glass particles) functions as an inorganic binder in the electroconductive paste composition and acts as the transport media to deposit the metal component onto the substrate during firing. The glass system is important for controlling the metallic crystallization on the silicon interface (which creates direct contact) and the metallic crystallite size inside the glass (which is the origin of the tunneling conductivity of the glass). The glass is also important for controlling the depth of the metallic crystallization penetration into the substrate, which could result in shunting of the p-n junction if not properly controlled.

The specific type of glass is not critical provided that it can give the desired properties to the paste composition, and both leaded and unleaded glasses are appropriate. Preferred glasses include lead borosilicate and bismuth borosilicate, but other lead-free glasses, such as zinc borosilicate, would also be appropriate. Lead-based glass frits may also include, but are not limited to, salts of lead halides, lead chalcogenides, lead carbonate, lead sulfate, lead phosphate, lead nitrate and organometallic lead compounds or compounds that can form lead oxides or slats during thermal decomposition. Lead-free glass frits may also include, but are not limited to, oxides or compounds of silicon, boron, aluminum, bismuth, lithium, sodium, magnesium, zinc, titanium or zirconium.

The glass particles preferably have a particle size of about 0.1 to about 10 microns, more preferably less than about 5 microns, and are preferably contained in the composition in an amount of about 0.5 to about 10 wt %, more preferably less than about 6 wt % based on the total weight of the paste composition. Such amounts provide the composition with appropriate adhesive strength and sintering properties.

The glass may optionally include one or more additives to further modify its properties. Exemplary glass additives include, without limitation, Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, lithium phosphates, etc. The selected glass frit additives content may be about 0.1 wt% to 10 wt% of the total paste, more preferably about 0.1 wt% to 3 wt% of each ingredient, and total frit additives are preferably about 0.1 wt% to 10 wt%, more preferably about 0.1 wt% to 5 wt%.

### Organic Vehicle

The particular organic vehicle or binder is not critical and may be one known in the art or to be developed for this type of application. For example, a preferred organic vehicle contains resins, solvents, and modifiers, such as ethylcellulose as a binder and terpineol as a solvent Other binders may include, but are not limited to, phenolic resins. Other solvents may include, but are not limited to, carbitol, hexyl carbitol, texanol, butyl carbitol, butyl carbitol acetate, or dimethyladipate or glycol ethers. The organic vehicle may also include surfactants and thixatropic agents known to one skilled in the art. Surfactants may include, but are not limited to, polyethyleneoxide, polyethyleneglycol, benzotriazole, poly(ethyleneglycol)acetic acid, lauric acid, oleic acid, capric acid, myristic acid, linolic acid, stearic acid, palmitic acid, stearate salts, palmitate salts, and mixtures thereof. Thixatropic agents known to one skilled in the art include gels and organics, such a those derived from natural substances like castor oil. Commercially available thixatropic agents may also be used. The organic vehicle is preferably present in the electroconductive paste composition in an amount of about 5 to about 30 wt %, more preferably less than about 20 wt %, based on the total weight of the composition.

### Metal Nanoparticulate Additive

The nanoparticulate additive according to the invention comprises electrically conductive nano-sized metal particles such as, but not limited to nickel, chromium, cobalt, titanium, alloys of cobalt, nickel, chromium, and titanium, silicides of these elements, and mixtures thereof. The metal or alloy nanoparticles preferably have a diameter of about 5 nm to about 2 microns, more preferably about 20 to about 800 nm, most preferably about 20 to about 500 nm. The nanoparticles (nanopowders) may be prepared by known techniques (see, for example, Kim, Soon-Gil et al "Colloids and film disposition ofNi nanoparticles for base metal electrode applications," Colloids and Surfaces A: Physiochem. Eng. Aspects, 337:96-101 (2009*)),* or they are commercially available from a number of sources, such as American Elements, Applied Nanotech Holdings, Inc. and U.S. Research Nanomaterials, Inc.

The nanoparticles are preferably contained in the electroconductive paste composition in an amount of about 0.05% to about 20 wt%, more preferably about 0.05% to about 10 wt%, most preferably about 0.05 to about 5 wt%, all weights based on the total weight of the paste composition. The metal nanoparticles may be added, for example, in the form of metal powders, alloy powders, lower valent metal silicide powders, such as Ni₂Si, Cr₅Si₃, and their mixtures. It is within the scope of the invention to include the additive in powder form or suspended in a liquid medium. In a particular embodiment, the metal nanoparticles are suspended in a solvent that is the same or miscible with the solvent used in the conductive paste.

The selected metal nanoparticles are included in the paste composition to decrease contact resistance with the silicon substrate through formation of lower contact resistance metal silicon compounds after reaction with silicon or metal nitrides after reaction with the antireflection coating Si₃N₄, improving efficiency of the resulting solar cell, Metal elements that are able to form low contact resistance metal silicon compounds are used for this application under conditions that the selected metals will not be deleterious to the solar cell under normal rapid thermal processing (RTP) metallization processing condition. The selected metals, alloy particles, or metal silicides should be chemically stable under normal paste manufacturing processes (shear mixing, three roll milling, etc.). Thus, after proper firing processes, low contact resistance metal silicide or nitrides can be formed, yielding solar cells that exhibit improved efficiency (increased fill factor and decreased contact resistance).

It is also within the scope of the invention to include additional additives in the electroconductive paste composition. For example, in addition to the glass additives described above, it may be desirable to include thickener (tackifier), stabilizer, dispersant, etc. compounds, alone or in combination. Such components are well known in the art. The amounts of such components, if included, may be determined by routine experimentation depending on the properties of the electroconductive paste that are desired.

The electroconductive paste composition may be prepared by any method for preparing a paste composition known in the art or to be developed; the method of preparation is not critical. The paste components may be mixed, such as with a mixer, then passed through a three roll mill, for example, to make a dispersed uniform paste.

Such a paste may then be utilized to form a solar cell by application of the paste to the antireflection layer on a substrate, such as by screen printing, and then firing to form an electrode (electrical contact) on the silicon substrate. Such a method of fabrication is well known in the art and described in European Patent Application Publication No. 1 713 093, for example. It is within the scope of the invention to utilize monocrystalline or multicrystalline silicon substrates. Solar cells using various substrates that are prepared with the inventive electroconductive paste exhibit decreased contact resistance and higher conversion efficiency relative to comparative cells prepared using conventional silver pastes. It has been found that solar cells with higher sheet resistance exhibit more significant increases in efficiency using the inventive electroconductive paste. It has also been found that solar cells with printed finer lines demonstrate more significant increases in efficiency using the inventive electroconductive paste, when fine line finger contact resistance is significantly affected by contact resistivity.

It is also within the scope of the invention to produce a solar cell containing two layers of electroconductive paste using double printing, a technology that has been adopted by industry. The first layer, applied to the substrate, comprises the inventive electroconductive paste containing metal, alloy, and/or silicide nanoparticles. A second layer, applied onto the first layer, may be the same or different from the first layer paste. The second layer paste may optionally also contain metal nanoparticles, but may omit the glass frit and/or organic vehicle. In a preferred embodiment, the second layer paste is a higher conductivity paste than the inventive paste comprising the first layer. It has been found that the first layer may function as seed layer to reduce contact resistance with the substrate, whereas the second layer may be formulated to increase line conductivity. Such two-layer solar cells are attractive because they exhibit both low contact resistance and low line resistance.

The invention will now be described in conjunction with the following, non-limiting examples.

### Example 1: Preparation of Solar Cells Using 70Ω/□ Multicrystallite Silicon Wafer

An electroconductive paste (Paste 1) is prepared by combining the components (silver powder, glass frit, glass additives, and organics) of a commercially available silver conductive paste, SOL9235H, commercially available from Heraeus Materials Technology LLC (W. Conshohocken, PA), about 0.05-5 wt% of nickel nanoparticles (three pastes with different percentages of Ni in this range), and at least one glass additive selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates. The nickel is utilized as a powder having a d₅₀ of 20 nm to 500 nm. The weight % of the nickel is based on the total weight of the resulting paste.

One exemplary paste of Paste 1 comprises about 85 wt. % silver particles, about 4-5 wt. % glass frit, about 8 wt. % organic vehicle, about 2 wt. % glass additive, and about 0.5 wt. % nickel nanoparticles (referred to as "Paste 1A"). The other two exemplary pastes constituting Paste 1 comprise the same amount of silver particles, glass frit, organic vehicle and glass additive, but one comprises about 0.2 wt. % nickel nanoparticles, while the other comprises about 0.7 wt. % nickel nanoparticles.

A solar cell is prepared as follows: On the backside of a ready-to-be metalized P-type multi-crystalline (mc) solar wafer having a sheet resistance of 70 Ω/□ (mc), an aluminum paste (RuXing 8252X) is printed and dried at 175°C. Paste 1A is applied to the front side of the wafer, printed, and dried at 150°C. The cell is then co-fired in a Despatch Ultra Flex oven at a temperature above 700°C for 3.5 seconds, Three identical 6" solar cells are prepared in this way from the three samples of paste. In addition, three identical control solar cells (Control Cell I) are prepared using the commercially available paste with no nickel additive on the same type of multi-crystalline solar wafer.

The resulting solar cells are tested using an I-V tester. The Xe arc lamp in the I-V tester is simulated using sunlight with a known intensity and the front surface of the solar cell is irradiated to generate the I-V curve. Using this curve, a number of parameters which provide for electrical performance comparison are determined, including short circuit current density (Jsc), short circuit current (Isc), open circuit voltage (Voc), fill factor (FF), shunt resistance (Rsh), series resistance (Rs), and Eta (efficiency).

The average electrical performance data for the three cells prepared using Paste 1A, and the three Control Cells I, are compared, All measurements were normalized to the average Control Cell values and are set forth in Table 1. It is found that the nickel nanoparticle-containing paste provides a notable improvement in fill factor and improved efficiency relative to the control paste.

**Table 1. Electrical Performance of Control Cell I and Paste 1A**

| | **Control Cell I** | **Paste 1A** |
|---|---|---|
| Eta (%) | 1.000 | 1.007 |
| Jsc (mA/cm²) | 1.000 | 0.995 |
| Voc (V) | 1.000 | 1.002 |
| FF (%) | 1.000 | 1.011 |
| Rsh (mΩ) | 1.000 | 1.636 |
| Rs (Ω) | 1.000 | 0.987 |

### Example 2: Preparation of Solar Cells Using 100 Ω/□ Multicrystallite Silicon Wafer

An electroconductive paste (Paste 2) is prepared by combining the components (silver powder, glass, glass additives, and organics) of a commercially available silver conductive paste, SOL9273MA, commercially available from Heraeus Materials Technology LLC (W. Conshohocken, PA), 0.05-5.0 wt% of nickel nanoparticles (three pastes with different percentages of Ni in this range), and at least one glass additive selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates. The nickel is utilized as a powder having a d₅₀ of 20 nm to 500 nm. The weight % of the nickel is based on the total weight of the resulting paste.

One exemplary paste of Paste 2 comprises about 85 wt. % silver particles, about 4-5 wt. % glass frit, about 8 wt % organic vehicle, about 2 wt. % glass additive, and about 0.2 wt. % nickel nanoparticles (referred to as "Paste 2A"). The other two exemplary pastes constituting Paste 2 comprise the same amount of silver particles, glass frit, organic vehicle and glass additive, but one comprises about 0.2 wt. % nickel nanoparticles, while the other comprises about 0.7 wt. % nickel nanoparticles.

A solar cell is prepared as follows: On the backside of a ready-to-be metalized P-type multi-crystalline (mc) solar wafer having a sheet resistance of 100 Ω/□ (mc), an aluminum paste (Monocrystal 1208D) is printed and dried at 175°C. Paste 2A is applied to the front side of the wafer, printed, and dried at 150°C. The cell is then co-fired in a Despatch Ultra flex furnace at a temperature > 700°C for a 3.8 seconds. Three identical solar cells are prepared in this way from the three samples of Paste 2A. In addition, three identical control solar cells (Control Cell II) are prepared using the commercially available paste with no nickel additive on the same type of multi-crystalline solar wafer.

The resulting solar cells are tested using an I-V tester as described in Example 1 and the same parameters recorded. Additionally, contact resistivity (ρ_{c}), expressed in Ωcm², is measured using TLM method.

The average electrical performance data for the three cells prepared using Paste 2A, and the three Control Cells II, are compared. All measurements were normalized to the average Control Cell values and are set forth in Table 2. It is found that the nickel nanoparticle-containing paste provides a notable improvement in fill factor and Eta, and lower contact resistivity relative to the control paste.

**Table 2. Electrical Performance of Control Cell II and Paste 2A**

| | **Control Cell II** | **Paste 2A** |
|---|---|---|
| Eta (%) | 1.000 | 1.118 |
| Jsc (mA/cm²) | 1.000 | 1.005 |
| Voc (V) | 1.000 | 1.002 |
| FF(%) | 1.000 | 1.115 |
| Rsh (mΩ) | 1.000 | 0.987 |
| Rs (Ω) | 1.000 | 0.732 |
| ρ_{c} (Ωcm2) I | 1.000 | 0.327 |

### Example 3: Preparation of Solar Cells Using 80 Ω/□ Monocrystalline Silicon Wafer

An electroconductive paste (Paste 3) is prepared by combining a commercially available silver conductive paste, SOL9235H, commercially available from Heraeus Materials Technology LLC (W. Conshohocken, PA), nickel nanoparticles having a particle size d₅₀ of 5nm to 300nm, and at least one glass additives selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates. The nickel is mixed with the paste and three roll milled. Paste 3 contains 0.1 %-3.0% nickel (three pastes with different percentages of Ni within this range) based on the total weight of the resulting paste.

An exemplary Paste 3A comprises about 85 wt. % silver particles, about 4-5 wt. % glass frit, about 8 wt. % organic vehicle, about 2 wt. % glass additive, and about 0.5 wt. % nickel nanoparticles. An exemplary Paste 3B comprises the same amount of silver particles, glass frit, organic vehicle, and glass additive, but comprises about 0.2 wt. % nickel nanoparticles. An exemplary Paste 3C comprises the same amount of silver particles, glass frit, organic vehicle, and glass additive, but comprises about 0.7 wt. % nickel nanoparticles.

Solar cells are prepared as follows: On the backside of a ready-to-be metalized P-type mono-crystalline solar wafer having a sheet resistance of 80 Ω/□, an aluminum paste (Monocrystal 1208D) is printed and dried at 175°C. Pastes 3A-3C are each applied to the front side of a wafer, printed, and dried at 150°C, The cells re then co-fired in a Despatch Ultra flex furnace at a temperature > 700°C for 3.5 seconds. Three identical solar cells are prepared using each of Pastes 3A-3C. Three additional solar cells are prepared as control (Control Cell III) using the commercially available paste with no nickel on a mono-crystalline solar wafer.

The resulting solar cells are tested using an I-V tester as described in Example 1. The average electrical performance data for the cells prepared using Pastes 3A-3C, and the three Control Cells III, are compared. All measurements were normalized to the average Control Cell values and are set forth in Table 3. It is found that Paste 3B, having the lowest amount of nickel nanoparticle as compared to Paste 3A and Paste 3C, provides notable fill factor improvement and better series resistance and efficiency relative to the control paste.

**Table 3. Electrical Performance of Control Cells III and Pastes 3A-3C**

| | **Control Cells III** | **Paste 3A** | **Paste 3B** | **Paste 3C** |
|---|---|---|---|---|
| Eta (%) | 1.000 | 0.999 | 1.005 | 0.993 |
| Jsc (mA/cm²) | 1.000 | 1.000 | 1.003 | 0.999 |
| Voc (V) | 1.000 | 1.000 | 1.000 | 0.997 |
| FF (%) | 1.000 | 0.998 | 1.002 | 0.997 |
| Rsh (mΩ) | 1.000 | 1.422 | 0.538 | 0.799 |
| Rs (Ω) | 1.000 | 1.006 | 0.988 | 1.026 |

### Example 4: Preparation of Two Layer Solar Cells Using 80 Ω/□ Monocrystalline Silicon Wafer

An electroconductive paste (Paste 4) is prepared by combining the components (silver powder, glass, glass additives, and organics) of a commercially available silver conductive paste, SOL9273MA, commercially available from Heraeus Materials Technology LLC (W. Conshohocken, PA), 0.05-5.0 wt% of nickel nanoparticles (three samples with different percentages in this range) having a particle size d₅₀ of 20 to 500 nm, and 0.1-2.0% of at least one glass additive selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates. All weight percents are based on the total weight of the resulting paste.

One exemplary paste of Paste 4 comprises about 85 wt. % silver particles, about 4-5 wt. % glass frit, about 8 wt. % organic vehicle, about 0.1-2 wt. % glass additive, and about 0.5 wt. % nickel nanoparticles (referred to as "Paste 4A"). The other two exemplary pastes constituting Paste 4 comprise the same amount of silver particles, glass frit, organic vehicle and glass additive, but one comprises about 0.2 wt. % nickel nanoparticles, while the other comprises about 0.7 wt. % nickel nanoparticles.

A solar cell is prepared as follows: On the backside of a ready-to-be metalized P-type mono-crystalline (sc) solar wafer having a sheet resistance of 70Ω/□, an aluminum paste (RuXing 8252X) is printed and dried at 175°C. A first layer of Paste 4A is applied onto the front side of the wafer, printed, and dried at 150°C. A second layer of commercially available silver paste SOL9273 (commercially available from Heraeus Materials Technology) is applied on top of the layer of Paste 6, printed, and dried at 150°C. The Example is not limited to the use of Heraeus SOL9273, and any silver conductive paste may be used as the second layer. The cell is then co-fired in a Despatch Ultra flex furnace at a temperature > 700°C for a 3.6 seconds. Three identical solar cells are prepared in this way.

In addition, three identical control solar cells (Control Cell IV) are prepared using two layers of commercially available silver pastes: a first layer of SOL9411 and a second layer of SOL9273 (both commercially available from Heraeus Materials Technology) on the same type of mono-crystalline solar wafer.

The resulting solar cells are tested using an I-V tester as described in Example 1 and the same parameters recorded. Additionally, contact resistivity (ρ_{c}) is measured using TLM method as described in Example 2.

The average electrical performance data for the three cells prepared using Paste 4A, and the three Control Cells IV, are compared. All measurements were normalized to the average Control Cell values and are set forth in Table 4. The nickel nanoparticle-containing paste yields a notable improvement in fill factor and a notable decrease in contact resistivity relative to the control paste.

**Table 4. Electrical Performance of Solar Cell Double Printed with Paste 4A and SOL9273**

| | **Control Cells IV** | **Example 4A** |
|---|---|---|
| Eta (%) | 1.000 | 1.002 |
| Jsc (mA/cm²) | 1.000 | 0.997 |
| Voc (V) | 1.000 | 1.000 |
| FF (%) | 1.000 | *1.005* |
| Rsh (mΩ) | 1.000 | 0.902 |
| Rs(Ω) | 1.000 | 0.961 |

### Example 5: Preparation of Solar Cell with and without Ni Alloys in the Silver Paste on 65 Ω/□ Multicrystalline Silicon Wafer

An electroconductive paste (Paste 5) is prepared by combining the components (silver powder, glass, glass additives, and organics) of a commercially available silver conductive paste, SOL9273MA, commercially available from Heraeus Materials Technology LLC (W. Conshohocken, PA), 0.05-5.0 wt% of a nickel alloy (ten samples with different percentages in this range) having a particle size d₅₀ of less than 500 nm, and 0.1-2.0% of at least one glass additive selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates. All weight percents are based on the total weight of the resulting paste.

A solar cell is prepared as follows: On the backside of a ready-to-be metalized P-type multi-crystalline (sc) solar wafer having a sheet resistance of 65Ω/□, an aluminum paste (RuXing 8204) is printed and dried at 175°C. Paste 5 is applied onto the front side of the wafer, printed, and dried at 150°C. The cell is then co-fired in a Despatch CDF furnace at a temperature > 700°C for a 3.6 seconds. Ten identical solar cells are prepared in this way.

In addition, ten identical control solar cells (Control Cell V) are prepared using the commercially available paste SOL9411 with no nickel additive on the same type of multi-crystalline solar wafer.

The resulting solar cells are tested using an I-V tester as described in Example 1 and the same parameters recorded. Additionally, contact resistivity (ρₒ) is measured using TLM methods as described in Example 2.

The average electrical performance data for the ten cells prepared using Paste 5 and the ten Control Cells V are compared. The nickel alloy nanoparticle-containing paste yields a notable improvement in fill factor and efficiency and a notable decrease in contact resistivity relative to the control paste.

### Example 6: Preparation of Solar Cells with and without Ni and Ni alloys in Silver paste on 80 Ω/□ Multicrystalline Silicon Wafer

Two electroconductive pastes (Paste 6 and 7) are prepared by combining the components (silver powder, glass, glass additives, and organics) of a commercially available silver conductive paste, SOL9273MA, commercially available from Heraeus Materials Technology LLC (W. Conshohocken, PA), 0.05-5.0 wt% of a nickel and nickel alloy nanoparticles mixture containing 5%-95% nickel, and 5%-95% nickel alloy, and 0.1-2.0% of at least one glass additive selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates (ten samples of each paste with different percentages in these ranges). The nickel and nickel alloy nanoparticles have a particle size d₅₀ of 20 nm to 500 nm.

A solar cell is prepared as follows: On the backside of a ready-to-be metalized P-type multi-crystalline (sc) solar wafer having a sheet resistance of 80Ω/□, an aluminum paste (RuXing 8204) is printed and dried at 175°C. Paste 6 or Paste 7 is applied onto the front side of the wafer, printed, and dried at 150°C, The cell is then co-fired in a Despatch CDF furnace at a temperature > 700°C for 3.6 seconds. Ten identical solar cells containing Paste 6 and ten identical solar cells containing Paste 7 are prepared in this way.

In addition, ten identical control solar cells (Control Cell VI) are prepared using commercially available silver paste SOL9273. The resulting solar cells are tested using an I-V tester as described in Example 1 and the same parameters recorded. Additionally, contact resistivity (ρ_{c}) is measured using TLM as described in Example 2.

The average electrical performance data for the twenty cells prepared using Paste 6 and Paste 7 and the ten Control Cells VI are compared. The nickel and nickel alloy-containing pastes yielded notable improvements in fill factor and notable increases in efficiency.

### Example 7: Multicrystalline Silicon Solar Cells Having Silver Paste with Nickel-Titanium Nanoparticle

An electroconductive paste (Paste 8) was prepared in order to ascertain the effect of including a nickel-titanium nanoparticle additive in an electroconductive paste. The paste comprised about 85 wt. % of silver particles, about 4 wt. % glass frit, about 9 wt. % organic vehicle and about 0.8 wt. % NiTi nanoparticle. Additionally, the paste comprises about 0.1-2 wt. % of at least one glass additive selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates. The NiTi nanoparticle component comprises approximately 50% nickel and 50% titanium. The NiTi nanoparticle is utilized as a powder having a d₅₀ of 20 nm to 500 nm.

A solar cell is prepared as follows: on the backside of a P-type multi-crystalline (mc) solar wafer (156 mm²) having a sheet resistance of 70 Ω/□, an aluminum paste (RuXing 8204) is printed and dried at 175°C. Paste 8 is screen printed on the front side of the wafer to form finger lines, at a speed of 150mm/s, using a screen having the following characteristics: mesh 290, wire thickness 20 microns, EOM 18 microns, finger line width 60 microns. The printed wafer was then dried at 150°C. The cell is then fired at a temperature above 700°C for approximately 3-4 seconds.

The resulting solar cells are tested using an I-V tester. The Xe arc lamp in the I-V tester is simulated using sunlight with a known intensity and the front surface of the solar cell is irradiated to generate the I-V curve. Using this curve, a number of parameters which provide for electrical performance comparison are determined, including solar cell efficiency (NCell), short circuit current (Isc), open circuit voltage (Voc), fill factor (FF), reverse saturation current (Irev2), shunt resistance (Rsh), series resistance (Rs), front grid resistance (Rfront) and contact resistance (Rc).

The electrical performance data of four finger lines printed from Paste 8 was gathered and an average was calculated. The results are set forth in Table 5. The paste achieved low series resistance and acceptable fill factor.

**Table 5. Average Electrical Performance of Paste 8**

| | **Exemplary Paste 8** |
|---|---|
| NCell (%) | 16.21 |
| FF(%) | 76.67 |
| Rs(Ω) | 0.00397 |
| Rsh (mΩ) | 49,221 |
| Rfront (Ω) | 0.0295 |
| Rc (mΩcm²) | 3.38 |
| Isc (mA) | 19.431 |
| Irev2 (A) | 1.295 |
| Voc (V) | 0.609 |

### Example 8: Multicrystalline Silicon Solar Cells Having Silver Paste with Lower Amount of Nickel-Titanium Nanoparticle

Two electroconductive pastes (Pastes 9 and 10) were prepared in order to ascertain the effect of including a lower amount of nickel-titanium nanoparticle (as compared to Example 7) in an electroconductive paste. The pastes comprised about 85 wt. % of silver particles, about 5 wt. % glass frit, about 8 wt. % organic vehicle, and about 0.1-2 wt. % of at least one glass additive selected from Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₂PO₄, LiCoO₂, LiNiO₂, Ni₃(PO₄)₂, NiO, or lithium phosphates. Paste 9 also comprised about 0.24 wt. % NiTi nanoparticle, and Paste 10 comprised about 0.20 wt. % NiTi nanoparticle. The NiTi nanoparticles component comprised about 50% nickel and about 50% titanium. The NiTi nanoparticles were utilized as a powder having a d₅₀ of 20 nm to 500 nm.

A solar cell (with each of Paste 9 and 10) was prepared according to the same parameters as set forth in Example 7, except that Paste 9 was printed on a P-type multi-crystalline (mc) solar wafer (156 mm²) having a sheet resistance of 80 Ω/□.

The resulting solar cells were then tested using an I-V tester. The Xe arc lamp in the I-V tester is simulated using sunlight with a known intensity and the front surface of the solar cell is irradiated to generate the I-V curve. Using this curve, a number of parameters which provide for electrical performance comparison are determined, including solar cell efficiency (NCell), short circuit current (Isc), open circuit voltage (Voc), fill factor (FF), reverse saturation current (Irev2), shunt resistance (Rsh), series resistance (Rs), front grid resistance (Rfront) and contact resistance (Rc).
The electrical performance data of four finger lines printed from Paste 9 and Paste 10 was gathered and an average was calculated. The results are set forth in Table 6. The pastes achieved excellent efficiency, fill factor and open circuit voltage.

**Table 6. Average Electrical Performance of Pastes 9 and 10**

| | **Paste 9** | **Paste 10** |
|---|---|---|
| NCell (%) | 16.41 | 16.34 |
| FF (%) | 75.93 | 75.77 |
| Rs (Ω) | 0.00429 | 0.00526 |
| Rsh(mΩ) | 89.45 | 61.7 |
| Rfront (Ω) | 0.0253 | 0.0228 |
| Voc(V) | 0.620 | 0.619 |

It will be appreciated by those skilled in the art that changes could be made to the embodiments described above without departing from the broad inventive concept thereof. It is understood, therefore, that this invention is not limited to the particular embodiments disclosed, but it is intended to cover modifications within the spirit and scope of the present invention as defined by the appended claims.

## Claims

1. An electroconductive paste composition comprising:
(a) silver particles;
(b) glass frit;
(c) electrically conductive metal, metal alloy, and/or metal silicide nanoparticles, wherein the nanoparticles have a particle diameter of about 5 nm to about 2 microns; and
(d) an organic vehicle.

2. The composition according to claim 1, wherein the nanoparticles comprise at least one selected from the group consisting of nickel, chromium, cobalt, titanium, and alloys, silicides, and mixtures thereof.

3. The composition according to any of the preceding claims, comprising about 40 to about 95% silver particles, about 0.5 to about 6 % glass frit, about 0.05 to 20 wt % metal nanoparticles, and about 5 to about 30% organic vehicle, all percentages being by weight based on a total weight of the composition.

4. The composition according to any of the preceding claims, wherein the nanoparticles have a particle diameter of about 20 nm to about 800 nm.

5. The composition according to any of the preceding claims, wherein the nanoparticles have a particle diameter of about 20 nm to about 500 nm.

6. The composition according to any of the preceding claims, wherein the nanoparticles are present in the composition in an amount of about 0.05 to about 20% by weight based on a total weight of the composition.

7. The composition according to any of the preceding claims, wherein the nanoparticles are present in an amount of about 0.05 to 10.0 wt%.

8. The composition according to any of the preceding claims, wherein the nanoparticles are present in an amount of about 0.05 to 5.0 wt %.

9. The composition according to any of the preceding claims, further comprising at least one additive selected from the group consisting of Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphates in an amount of about 0.1 to 3.0 wt %.

10. A solar cell electrode formed by applying an electroconductive paste composition to a substrate and firing the paste to form the electrode, wherein the electroconductive paste composition comprises:
(a) silver particles;
(b) glass frit;
(c) electrically conductive metal, metal alloy, and/or metal silicide nanoparticles, wherein the nanoparticles have a particle diameter of about 5 nm to about 2 microns; and
(d) an organic vehicle.

11. The solar cell electrode according to claim 10, wherein the nanoparticles are at least one selected from the group consisting of nickel, chromium, cobalt, titanium, and alloys, silicides, and mixtures thereof.

12. The solar cell electrode according to claims 10-11, wherein the nanoparticles have a particle diameter of about 20 nm to about 800 nm.

13. The solar cell electrode according to claims 10-12, wherein the nanoparticles have a particle diameter of about 20 nm to about 500 nm.

14. The solar cell electrode according to claims 10-13, wherein the nanoparticles are present in the composition in an amount of about 0.05 to about 20% by weight based on a total weight of the composition.

15. The solar cell electrode according to claims 10-14, wherein the nanoparticles are present in an amount of about 0.05 to 10.0 wt%.

16. The solar cell electrode according to claims 10-15, wherein the nanoparticles are present in an amount of about 0.05 to 5.0 wt %.

17. The solar cell electrode according to claims 10-16, wherein the electroconductive paste composition further comprises at least one additive selected from the group consisting of Al₂O₃, ZnO, Li₂O, Ag₂O, AgO, MoO₃, TiO₂, TeO₂, CoO, Co₂O₃, Bi₂O₃, CeO₂, CeF₄, SiO₂, MgO, PbO, ZrO₂, HfO₂, In₂O₃, SnO₂, P₂O₅, Ta₂O₅, B₂O₃, Ag₃PO₄, LiCoO₂, LiNiO₂, Ni₃(PO₄)₂, NiO, or lithium phosphate in an amount of about 0.1 to 3.0 wt %.

18. A solar cell electrode formed by applying a first layer of a first electroconductive paste composition to a substrate and drying the paste, applying a second layer of a second electroconductive paste composition to the first layer, and firing the two layers to form the electrode, wherein the first electroconductive paste composition comprises:
(a) silver particles;
(b) glass frit;
(c) electrically conductive metal, metal alloy, and/or metal silicide nanoparticles, wherein the nanoparticles have a particle diameter of about 5 nm to about 2 microns; and
(d) an organic vehicle;
and wherein the second electroconductive paste is the same as or different from the first electroconductive paste.

19. The solar cell electrode according to claim 18, wherein the nanoparticles are at least one selected from the group consisting of nickel, chromium, cobalt, titanium, and alloys, silicides, and mixtures thereof.

20. A method of forming a solar cell electrode comprising applying a layer of a first electroconductive paste composition to a substrate and firing the paste to form the electrode, wherein the first electroconductive paste composition comprises:
(a) silver particles;
(b) glass frit;
(c) electrically conductive, metal, metal alloy, and/or metal silicide nanoparticles, wherein the nanoparticles have a particle diameter of about 5 nm to about 2 microns; and
(d) an organic vehicle.

21. The method according to claim 20, wherein the nanoparticles are at least one selected from the group consisting of nickel, chromium, cobalt, titanium, and alloys, silicides, and mixtures thereof.

22. The method according to claims 20-21, further comprising forming a layer of a second electroconductive paste composition on the layer of the first electroconductive paste composition.
